# EUROPÄISCHE PATENTSCHRIFT

(11) **EP 2 600 521 B1**
(45) Veröffentlichungstag und Bekanntmachung des Hinweises auf die Patenterteilung: **04.09.2019**
(21) Anmeldenummer: 12007977.7
(22) Anmeldetag: 28.11.2012
(51) Int. Cl.: H03B 11/02, F41H 13/00, H01T 9/00, H01J 23/36, H01J 25/50

(54) **Resonatoranordnung für Mikrowellengenerator**
Resonator assembly for microwave generator
Agencement de résonateur pour générateur de micro-ondes

(30) Priorität: 03.12.2011 DE 102011120290
(43) Veröffentlichungstag der Anmeldung: 05.06.2013
(73) Patentinhaber: Diehl Defence GmbH & Co. KG, 88662 ÜBERLINGEN (DE)
(72) Erfinder: Dommer, Josef, DE - 90451 Nürnberg (DE)
(74) Vertreter: Diehl Patentabteilung

(56) Entgegenhaltungen:
- WO-A1-2010/098699
- DE-A1- 10 151 565
- DE-A1- 10 151 565
- GB-A- 726 266
- US-A- 2 240 941
- US-A- 4 175 277

## Beschreibung

Die vorliegende Erfindung betrifft eine Resonatoranordnung für einen Mikrowellengenerator. Ferner betrifft die vorliegende Erfindung einen Mikrowellengenerator, welcher eine entsprechende Anordnung aufweist.

Die Funktion eines Mikrowellengenerators beruht darauf, dass eine Hochspannungsbatterie, etwa eine gemäß dem Prinzip der Marx'schen Stoßspannungsschaltung parallel aufgeladene und dann in Serie geschaltete Kondensatorbatterie über eine Funkenstrecke entladen wird, die sich zwischen den Elektroden einstellt, über welche die Hochspannung der Serienschaltung dann anliegt. Solch ein Entladungsvorgang führt zu einem steil einsetzenden und stark oszillierenden Stromfluss in den Elektroden und in zusätzlich daran elektrisch leitend angeschlossenen antennenartigen Leitern und damit zu einer entsprechend breitbandigen Abstrahlung eines Mikrowellenspektrums hoher Energiedichte. Dieses kann in der Umgebung eines solchen Mikrowellengenerators den Funkverkehr beeinträchtigen sowie elektronische Schaltungen eingangsseitig stören oder sogar zerstören.

Die Betriebsdauer eines Mikrowellengenerators wird vor allem durch den Verschleiß an den Elektroden bestimmt. Zur Erhöhung der Betriebsdauer ist man dazu übergegangen, durch den Einsatz verstellbarer Elektroden, den Weg der Funkenstrecke nachzustellen. Im Betrieb wird an eine bewegliche Elektrode eine Hochspannung von mehreren 100 kV zugeführt.

Aus der DE 101 51 565 A1 ist eine Anordnung zur Hochspannungszuführung für einen Mikrowellengenerator gemäß dem Oberbegriff des Anspruchs 1 bekannt. Dieser Mikrowellengenerator umfasst eine pilzförmig abgerundete, über eine Spindel verstellbare Elektrode. Die Spindel steht mit einem Kontaktelement in Form einer radialen Brücke mit einem hohlzylindrischen, elektrischen Leiter, der als Abstrahlantenne wirkt, in Verbindung. Zur Herstellung eines elektrischen Kontaktes berührt bei dieser Konstruktion die Innenfläche der axialen Durchgangsbohrung der radialen Brücke die Außenumfangsfläche der die erste Elektrode tragenden Spindel. Bei Stromfluss von Hochspannung kommt es über diese metallischen Berührflächen wegen des erhöhten Übergangswiderstandes zu Funkenbildung, welche zu einer Materialerosion und damit langfristig zu einer Zerstörung führt. Sofern ein Mikrowellengenerator unter Isoliergas betrieben wird, entstehen bei der Funkenentladung chemisch besonders aggressive Reaktionsprodukte, welche zu einer zusätzlichen Oxidation und damit zu einer weiteren Verschlechterung des Kontaktmaterials führen. Der durch den Elektrodenverschleiß entstehende Materialabtrag schlägt sich auf den Oberflächen nieder und erhöht hierdurch den Übergangswiderstand, sodass der verstellbare Elektrodenkontakt in kurzer Zeit zerstört werden kann.

Die Patentdokumente WO2010/098699, US2240941, US4175277 und DE10151565 lehren die Realisierung verformbarer Elektroden-Kontaktelemente in einem Vakuumschalter bzw. in Funkenstrecken-basierten Mikrowellengeneratoren.

Die Aufgabe der vorliegenden Erfindung besteht darin, eine Anordnung der gattungsgemäßen Art zur Verfügung zu stellen, mittels der die Betriebsdauer eines Mikrowellengenerators erhöht werden kann.

Darüber hinaus soll ein Mikrowellengenerator mit einer erhöhten Betriebsdauer zur Verfügung gestellt werden.

Diese Aufgabe wird durch die Anordnung nach Anspruch 1 gelöst. Hierbei ist hervorzuheben, dass das Kontaktelement mit der Elektrode oder deren Halterung bewegungsfest in Verbindung steht, so dass die gegenüberliegenden Kontaktflächen auch bei Veränderung der Lage der ersten Elektrode zur zweiten Elektrode gleich bleiben und das Kontaktelement verformbar ist. Dadurch, dass das Kontaktelement verformbar ist, kann erreicht werden, dass trotz einer Veränderung der Position der ersten Elektrode beim Nachstellen der Funkenstrecke die Kontaktflächen unverändert aneinander liegen bleiben. Die Erfindung ermöglicht es daher, eine feste, permanente elektrische Verbindung des Kontaktelements zur ersten Elektrode oder deren Halterung vorzusehen. Auch zum hohlzylindrischen elektrischen Leiter hin kann eine feste, permanente elektrische Verbindung vorgesehen sein. Durch den bewegungsfesten elektrischen Kontakt zwischen dem Kontaktelement und der Elektrode bzw. deren Halterung, bzw. zwischen Kontaktelement und Resonator wird eine funkenbedingte Erosion vermieden und damit eine deutliche Verlängerung der Betriebsdauer erreicht. Sofern die erste Elektrode in ihrem Abstand zur zweiten Elektrode verstellt werden muss, werden bedingt durch die Verformbarkeit des Kontaktelements Verspannungen, die bei einem nicht verformbaren Kontaktelement normalerweise entstehen würden, von dem verformbaren Kontaktelement kompensiert. Bei Verstellung von erster zu zweiter Elektrode ist es im Gegensatz zum Stand der Technik nicht notwendig, dass sich die Berührflächen zwischen Kontaktelement und erster Elektrode, bzw. deren Halterung, oder zwischen erster Elektrode und Resonator verändern.

Zweckmäßigerweise handelt es sich bei dem Kontaktelement um ein solches, welches elastisch verformbar ist, so dass bei Veränderung der Lage der ersten Elektrode normalerweise auftretende Verspannungen von der Elastizität des Kontaktelements unter Beibehaltung der bewegungsfesten Verbindung von Kontaktelement zu Elektrode oder zu deren Halterung bzw. zu dem Resonator kompensierbar sind.

Alternativ kann das Kontaktelement auch plastisch verformbar sein.

Gemäß einer zweckmäßigen Ausgestaltung der Erfindung umfasst das Kontaktelement einen ringförmigen inneren Kontaktbereich, der für die Kontaktierung der ersten Elektrode bzw. deren Halterung vorgesehen ist, einen ringförmigen äußeren Kontaktbereich, der für die Kontaktierung eines äußeren, die beiden Elektroden umgebenden hohlzylindrischen, elektrischen Leiters vorgesehen ist, sowie einen dazwischen befindlichen Bereich, der eine Mehrzahl von vorzugsweise abwechselnd angeordneten Verformungsabschnitten oder Federelementen sowie Durchbrüchen, vorzugsweise in abwechselnder ringförmiger Anordnung, umfasst.

Hierbei ist das Kontaktelement nach Art eines Rings aufgebaut, dessen äußerer Kontaktbereich sowie innerer Kontaktbereich zueinander in ihrer ebenen Position durch Verformung des Kontaktelements veränderbar ist.

Es ist vorteilhaft, wenn die Verformungsabschnitte bzw. Federelemente eine gedachte Verbindungslinie zwischen innerem Kontaktbereich sowie äußerem Kontaktbereich in der Höhe überragen. Ein derart geformtes Kontaktelement ermöglicht eine wirksame elektrische Kontaktierung der ersten Elektrode bei vergleichsweise geringer radialer Ausladung, was eine kleine Bauweise Resonators ermöglicht.

Dadurch, dass der zwischen dem äußeren und inneren Kontaktbereich befindliche Bereich eine Mehrzahl von Durchbrüchen aufweist, werden bei jeder Funkenentladung entstehende Druckstöße im Resonator bzw. Mikrowellengenerator kaum behindert. Hierdurch ist das Bauteil keinen oder wenn dann nur geringen Druckdifferenzen ausgesetzt, wodurch die Gefahr eines Schwingens reduziert und die Haltbarkeit erhöht werden kann.

Vorteilhaft können die Federelemente als Welle, beispielsweise als im Wesentlichen U-förmige Welle oder als Winkel ausgebildet sein, oder V-förmig. Hierbei ist die Leitungslänge und damit die Induktivität im Verhältnis zum notwendigen Verstellweg der Funkenstrecke (welcher üblicherweise 2 bis 3 mm beträgt) gering, wodurch die elektrischen Eigenschaften des Resonators, wie z. B. die Frequenz, nicht oder nur gering beeinflusst werden. Auf Grund dieser Formgestaltung ist es möglich, kleinere Abmessungen des Resonators einzuhalten, wodurch die Erzeugung höherer Frequenzen erleichtert wird.

Zweckmäßigerweise können der innere, äußere Kontaktbereich sowie die Federelemente eine identische Materialstärke aufweisen. In diesem Fall kann das Kontaktelement in einfacher Weise aus einem flächigen Ausgangsmaterial, z. B. Stahlblech, ausgestanzt und anschließend entsprechend umgeformt werden.

Alternativ kann das jeweilige Federelement auch im Rahmen der Fertigung mit dem inneren sowie äußeren Ring verbunden z. B. verschweißt werden, sofern z. B. unterschiedliche Materialstärken bevorzugt werden.

Anstelle von bandförmigen Federelementen sind auch drahtförmige Federelemente geeignet. Sie haben den Vorteil einer möglichst großen Durchlassfläche.

Vorzugsweise ist das Kontaktelement zur Herstellung einer bewegungsfesten elektrischen Verbindung an der ersten Elektrode und/oder deren Halterung eingespannt. Eine Funkenbildung kann hierdurch vermieden werden. Beispielsweise kann hierzu der umlaufende innere Rand des Kontaktelements zwischen der ersten Elektrode und deren Halterung eingesetzt und mittels einer Schraubverbindung eingespannt werden.

Hierbei ist ein Spalt vorgesehen, in den der umlaufende innere Rand des Kontaktelements für das Einspannen eingreift.

Alternativ kann das Kontaktelement auch einstückig mit der ersten Elektrode, bzw. deren Halterung oder einstückig mit dem hohlzylindrischen elektrischen Leiter ausgebildet sein.

Die vorliegende Erfindung betrifft weiterhin einen Mikrowellengenerator mit einer Stoßspannungsschaltung gemäß dem Oberbegriff des Anspruchs 9, welcher durch eine Anordnung gemäß mindestens einem der Ansprüche 1 bis 8 gekennzeichnet ist.

Zweckmäßige Ausgestaltungen der vorliegenden Erfindung werden anhand von Zeichnungsfiguren nachstehend näher erläutert. Es zeigen:

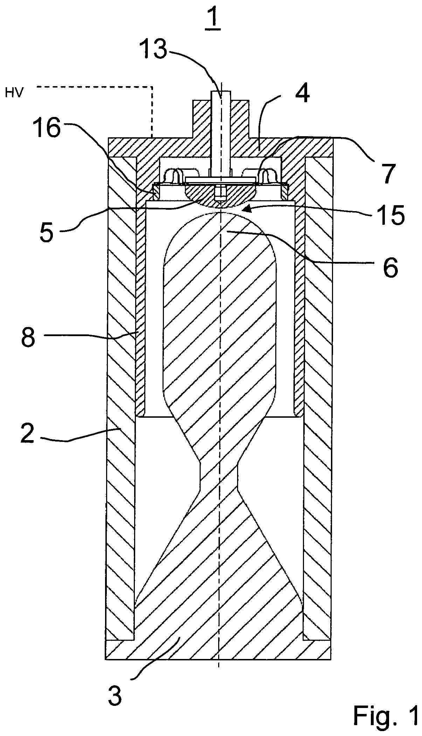

- Fig. 1: eine prinzipielle Schnittdarstellung entlang der Längsachse eines Mikrowellengenerator mit einer Anordnung gemäß einer beispielhaften Ausgestaltung der vorliegenden Erfindung;
- Fig. 2: verschiedene Ausgestaltungen von verformbaren Kontaktelementen gemäß der vorliegenden Erfindung sowie
- Fig. 3: eine vergrößerte Schnittdarstellung desjenigen Bereichs des in Fig. 1 dargestellten Mikrowellengenerators, in dem sich die Funkenstrecke befindet.

Die Bezugsziffer 1 bezeichnet eine zweckmäßige Ausgestaltung eines Mikrowellengenerators für eine Hochspannungsfunkenstrecke gemäß der vorliegenden Erfindung. Er umfasst ein zylindrisches, elektrisch isolierendes Gehäuse 2, welches an der Unterseite mit einem ersten Gehäusedeckel 3 sowie an dessen Oberseite mit einem zweiten, im Ausführungsbeispiel elektrisch leitenden Gehäusedeckel 4 verschlossen ist. Im Inneren des Gehäuses 2 befinden sich zwei einander gegenüberliegende Elektroden 5, 6. Die innere (zweite) Elektrode 6 ist im Wesentlichen keulenförmig mit einem mittleren zylindrischen Abschnitt konstanten Durchmessers ausgebildet.

Die gegenüberliegende (erste) Elektrode 5 ist kleiner und kappenförmig ausgebildet. Sie wird getragen von einer Halterung 13, die einen stabförmigen Teil sowie eine stirnseitig daran befestigte Endplatte aufweist.

Der zwischen der ersten Elektrode 5 und der zweiten Elektrode 6 befindliche Spalt stellt eine Funkenstrecke 15 dar. Die Funkenstrecke 15 kann durch axiale Verstellung der Position der ersten Elektrode 5 verändert werden, so dass bei Bedarf ein Nachstellen der Funkenstrecke 15 durch axiale Verstellung der ersten Elektrode 5 durchgeführt werden kann. Hierzu kann ein (nicht dargestellter) Stellmotor mit der Halterung 13 der ersten Elektrode verbunden sein. Die erste Elektrode 5 sowie die zweite Elektrode 6 werden ringförmig von einem hohlzylindrischen, elektrischen Leiter 8 umgeben, der gleichzeitig mittels eines Kontaktelements 7 mit der ersten Elektrode 5 elektrisch verbunden ist. Der Leiter 8 geht einstückig über in den ersten Gehäusedeckel 4. Letzterer steht mit einer Hochspannungsquelle (HV) in Verbindung. Hierbei handelt es sich um eine übliche Stossspannungsschaltung der Art, wie sie beispielsweise in der DE 101 51 565 A1 dargestellt ist.

Die Elektroden 5, 6 und die mit diesen elektrisch verbundenen Teile bilden eine Kapazität, in der Hochspannungsenergie gespeichert wird, bis es infolge eines Funkenüberschlags entlang der Funkenstrecke 15 zur schlagartigen Energieentladung kommt. Durch das Zünden der Funkenstrecke 15 kommt es zu kräftig strahlenden Stromoszillationen mit einer steilen Stromanstiegsflanke. Die Elektroden 5, 6 bilden zusammen mit dem hohlzylindrischen elektrischen Leiter 8 einen Resonator (Antenne), durch den es möglich wird, einen Mikrowellenimpuls hoher Frequenz abzustrahlen.

Gemäß der Erfindung ist das Kontaktelement 7 bewegungsfest elektrisch verbunden und zwar sowohl mit dem hohlzylindrischen elektrischen Leiter 8 als auch mit der ersten Elektrode 5. Bewegungsfest verbunden bedeutet hierbei, dass die Verbindung mit dem jeweiligen angrenzenden Bauteil ohne Veränderung der Berührungsflächen bestehen bleibt, auch wenn die Position der ersten Elektrode 5 zur Position der zweiten Elektrode 6 zwecks Nachstellung der Funkenstrecke 15 verändert werden muss. Eine derartige Positionsänderung wird ermöglicht, da das Kontaktelement als verformbares Kontaktelement ausgestaltet ist. Bei einer Positionsänderung der ersten Elektrode 5 bei einem starren Kontaktelement vergleichsweise entstehende Spannungen werden aufgrund des verformbaren Kontaktelements 7 der vorliegenden Erfindung kompensiert.

Dadurch, dass eine bewegungsfeste elektrische Verbindung des Kontaktelements 7 mit den benachbarten Bauteilen vorgesehen ist, ist der Übergangswiderstand gering und die Materialerosion durch Funkenbildung wird wirksam unterbunden.

Besonders vorteilhaft ist es, wenn das Kontaktelement 7 als elastisch verformbares Kontaktelement ausgebildet ist. Das Kontaktelement 7 besteht aus elektrisch leitfähigem Material, z. B. einem Stahlblech oder dgl.

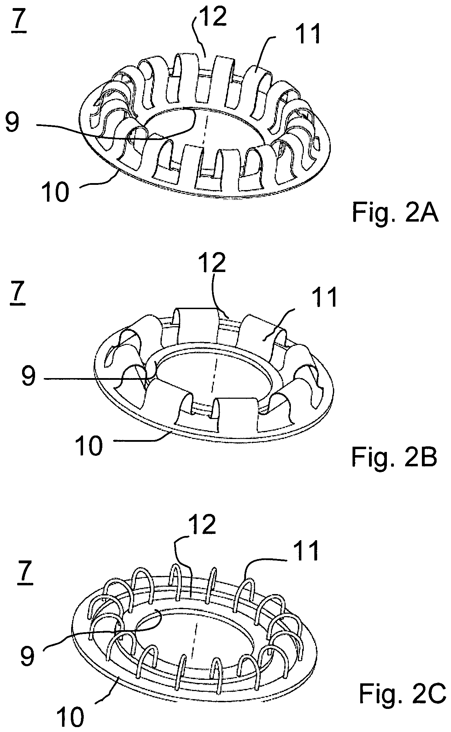

Die Fig. 2A bis 2C zeigen verschiedene Ausgestaltungen eines solchen elastisch verformbaren Kontaktelements 7.

Allen Ausgestaltungen ist gemeinsam, dass ein innerer, ringförmiger Kontaktbereich 9 sowie ein äußerer, ringförmiger Kontaktbereich 10 vorgesehen sind. Die Kontaktbereiche 9, 10 dienen dazu, mit dem jeweiligen angrenzenden Bauteil die bewegungsfeste, elektrische Verbindung einzugehen.

Allen Ausgestaltungen ist ebenfalls gemeinsam, dass sich entlang des Umfangs des jeweiligen, ringförmigen Kontaktelements 7 einzelne die elastische Verformbarkeit bewirkende Federelemente 11 sowie Durchbrüche 12 abwechselnd aneinanderreihen, so dass zum einen über die Federelemente 11 ein radial symmetrischer Stromfluss über die gesamt Fläche des Kontaktelements 7 ermöglicht wird, zum anderen aufgrund der Durchbrüche 12 eine offene Bauform vorliegt. Diese hat den Vorteil, dass durch die Funkenentladung entstehende Druckstöße im Resonator durch das Kontaktelement 7 nicht oder nicht wesentlich behindert werden. Dies wiederum resultiert in keinen oder nur unwesentlichen mechanischen Druckbeaufschlagungen wegen Druckdifferenzen, wodurch eine Anregung zum Schwingen reduziert und die Dauerhaltbarkeit des Mikrowellengenerators erhöht werden kann.

Die einzelnen Federelemente 11 besitzen eine im wesentlichen U-förmige Form und überragen demzufolge eine gedachte Verbindungsebene zwischen inneren Kontaktbereich 9 und äußeren Kontaktbereich 10. Hierdurch wird es ermöglicht, einerseits die Überschlagsgefahr gering zu halten. Andererseits ist die Leitungslänge und damit die Induktivität im Verhältnis zum Verstellweg der ersten Elektrode 5 (üblicherweise 2 bis 3 mm) gering, wodurch die elektrischen Eigenschaften des Resonators wie zum Beispiel seine Frequenz in vorteilhafter Weise nicht oder nur unwesentlich beeinflusst werden.

Bei der Darstellung der Ausgestaltung des Kontaktelements 7 nach Fig. 2A handelt es sich um ein Kontaktelement 7, welches aus einem flächigen Ausgangsmaterial (z. B. Stahlblech) beispielsweise durch Stanzen hergestellt und anschließend zur Herstellung der U-förmigen Federelemente 11 umgeformt wird. Das Kontaktelement 7 hat infolgedessen über seinen gesamten Bereich eine gleichbleibende Materialstärke. Die Federelemente 11 haben eine bandförmige Form.

Bei der Ausgestaltung des Kontaktelements 7 nach Fig. 2B ist die Materialstärke im Bereich der Federelemente 11 geringer als am inneren Kontaktbereich 9 beziehungsweise am äußeren Kontaktbereich 10. Die Federelemente 11 sind hierbei folglich nachträglich mit dem inneren Kontaktbereich 9 sowie dem äußeren Kontaktbereich 10 verbunden worden. Die Federelemente 11 haben ebenfalls eine bandförmige Form.

Bei der Ausgestaltung nach Fig. 2C ist statt der bandförmigen Federelemente jeweils ein drahtförmiges, U-geformtes Federelement 11 vorgesehen. Diese Ausgestaltung bildet einen besonders großen Gesamtdurchlassquerschnitt.

Allen Ausführungsformen ist gemeinsam, dass aufgrund der Formgebung die Federelemente 11 eine elastische Verformung möglich ist und zudem ein vergleichsweise schmales Kontaktelement 7 realisiert werden kann, mit der Folge, dass der Abstand der ersten Elektrode 5 beziehungsweise deren Halterung 13 zum hohlzylindrischen elektrischen Leiter 8 gering bleibt und demzufolge ein in seinen Dimensionen kleiner Resonator realisiert werden kann. Aufgrund der kleinen Dimensionen des Resonators können wiederum hohe Frequenzen erzeugt werden. Die durch die einzelnen Durchbrüche 12 bedingte offene Bauweise ermöglicht es, Staub, der bei der Funkenentladung, an der Elektrode als Verschleiß entsteht, aus dem Bereich der Elektroden d. h. Funkenentladung abzutransportieren, wodurch die Lebensdauer des Mikrowellengenerators erhöht werden kann.

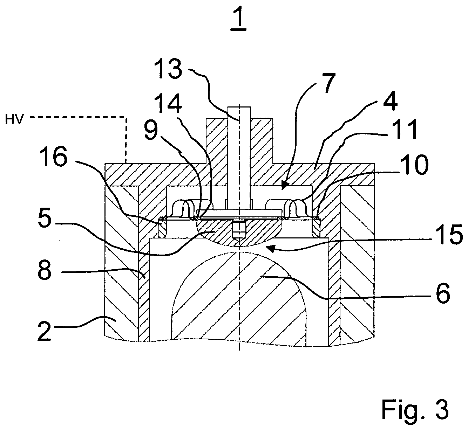

Zur Gewährleistung einer bewegungsfesten Verbindung des Kontaktelements 7 ist, wie in Fig. 3 dargestellt, der innere Kontaktbereich 9 innerhalb eines Spalts 14 zwischen der ebenen Rückseite der ersten Elektrode 5 sowie der gegenüberliegenden Endplatte der Halterung 13 fest (durch eine nicht dargestellte Verschraubung) eingespannt. Auf der gegenüberliegenden Seite ist der äußere Kontaktbereich 10 zwischen dem zweiten Gehäusedeckel 4 und einem Gewindering 16 eingespannt, so dass das Kontaktelement 7 an beiden Seiten bewegungsfest gehalten ist.

Wird nun die Position der Elektrode 5 verändert, so vollzieht das Kontaktelement 7 im Bereich dessen Federelemente 11 eine Verformung vergleichbar mit einem Abwälzvorgang. Die jeweiligen Berührungsflächen an dem Kontaktelement 7 bleiben hierbei unverändert.

Zur Herstellung einer bewegungsfesten Verbindung eignen sich auch andere Verbindungsarten, sofern sie einen elektrischen Kontakt zulassen. Denkbar ist zum Beispiel eine Schweißverbindung, eine Lötverbindung, Nietverbindung oder auch Klebeverbindung. Wesentlich ist, dass Maßnahmen zur Gewährleistung eines elektrischen Kontakts getroffen sind.

Die in den Fig. 2 A bis 2 C dargestellten Kontaktelemente 7 umfassen Federelemente 11, die eine elastische Verformung ermöglichen. Alternativ können auch Federelemente vorgesehen sein, die eine plastische Verformung bedingen.

Anstelle einer Verbindung des Kontaktelements 7 mit der ersten Elektrode 5 beziehungsweise deren Halterung 13 ist es alternativ auch möglich, das Kontaktelement an der ersten Elektrode 5 beziehungsweise an deren Halterung 13 als integraler Bestandteil eines einstückigen Bauteils vorzusehen. Dies gilt alternativ dazu oder in Kombination damit auch für das gegenüberliegende Bauteil in Form des hohlzylindrischen elektrischen Leiters 8 beziehungsweise des damit einstückigen Gehäusedeckels 4.

Die vorliegende Erfindung ermöglicht es, das Auftreten einer Funkenbildung im Bereich der ersten Elektrode wirksam zu verhindern und resultiert als Folge davon in einer deutlichen Verlängerung der Betriebsdauer eines Mikrowellengenerators.

### Bezugszeichenliste

- 1: Mikrowellengenerator
- 2: Gehäuse
- 3: erster Gehäusedeckel
- 4: zweiter Gehäusedeckel
- 5: erste Elektrode
- 6: zweite Elektrode
- 7: Kontaktelement
- 8: hohlzylindrischer elektrischer Leiter
- 9: innerer Kontaktbereich
- 10: äußerer Kontaktbereich
- 11: Federelement
- 12: Durchbruch
- 13: Halterung (erste Elektrode)
- 14: Spalt
- 15: Funkenstrecke
- 16: Gewindering

## Patentansprüche

1. Resonatoranordnung für einen Mikrowellengenerator (1) umfassend:
ein Gehäuse (2),
einen innerhalb des Gehäuses (2) positionierten, hohlzylindrischen elektrischen Leiter (8),
eine erste Elektrode (5),
eine zweite Elektrode (6), wobei beide Elektroden (5, 6) zueinander beabstandet sind und im Bereich des Leiters (8) eine Funkenstrecke (15) bilden, sowie
ein Kontaktelement (7) zur Herstellung eines elektrischen Kontakts zwischen Leiter (8) und erster Elektrode (5),
wobei die erste Elektrode (5) zur Anpassung der Länge der Funkenstrecke (15) in ihrer Position verstellbar ist,
wobei zumindest ein Kontaktbereich (9) des Kontaktelements (7) mit der ersten Elektrode (5) oder deren Halterung (13) bewegungsfest in Verbindung steht, und
wobei das Kontaktelement (7) verformbar ist, so dass die sich gegenüberliegenden Kontaktflächen von Leiter (8) und erster Elektrode (5) auch bei Verstellung der Position der ersten Elektrode (5) zur zweiten Elektrode (6) in elektrischem Kontakt bleiben,
wobei ein weiterer Kontaktbereich (10) des Kontaktelements (7) mit dem hohlzylindrischen elektrischen Leiter (8) bewegungsfest in Verbindung steht,
**dadurch gekennzeichnet,**
**dass** das Kontaktelement (7) folgendes umfasst:
einen inneren Kontaktbereich (9), der für die elektrische Kontaktierung der ersten Elektrode (5) bzw. deren Halterung (13) vorgesehen ist,
einen äußeren Kontaktbereich (10), der für die elektrische Kontaktierung des hohlzylindrischen elektrischen Leiters (8) vorgesehen ist, sowie
einen dazwischen befindlichen , Bereich, der eine Mehrzahl von Verformungsabschnitten sowie Durchbrüchen (12) umfasst,
**dass** zur Herstellung der bewegungsfesten elektrischen Verbindungen eine Klemmverbindung, Schraubverbindung, Schweißverbindung, Lötverbindung oder elektrisch leitende Klebeverbindung vorgesehen ist, und
**dass** das Kontaktelement (7) in einen zwischen erster Elektrode (5) und deren Halterung (13) vorgesehen Spalt (14) eingreift.

2. Anordnung nach Anspruch 1,
wobei das Kontaktelement (7) elastisch verformbar ist.

3. Anordnung nach Anspruch 1,
wobei das Kontaktelement (7) plastisch verformbar ist.

4. Anordnung nach einem der vorangehenden Ansprüche,
wobei es sich bei den Verformungsabschnitten um Federelemente (11) handelt.

5. Anordnung nach Anspruch einem der vorangehenden Ansprüche,
wobei die Verformungsabschnitte oder Federelemente (11) eine gedankliche Verbindungsebene zwischen innerem Kontaktbereich (9) sowie äußerem Kontaktbereich (10) in der Höhe überragen.

6. Anordnung nach einem der vorangehenden Ansprüche,
wobei die Verformungsabschnitte oder Federelemente (11) wellig oder gewinkelt ausgebildet sind.

7. Anordnung nach einem der vorangehenden Ansprüche,
wobei der innere Kontaktbereich (9), der äußere Kontaktbereich (10) sowie die Verformungsabschnitte oder Federelemente (11) identische Materialstärken aufweisen.

8. Anordnung nach einem der vorangehenden Ansprüche,
wobei die Verformabschnitte oder Federelemente (11) bandförmig oder drahtförmig ausgebildet sind.

9. Mikrowellengenerator mit einer Stoßspannungsschaltung sowie einer zwischen einer ersten Elektrode (5) und einer zweiten Elektrode (6) angeordneten Funkenstrecke (7), wobei die erste Elektrode (5) zur Veränderung der Länge der Funkenstrecke in ihrer Position veränderbar ist,
**dadurch gekennzeichnet,**
**dass** der Mikrowellengenerator (1) eine Anordnung gemäß mindestens einem der vorhergehenden Ansprüche umfasst.

## Claims

1. Resonator arrangement for a microwave generator (1) comprising:
a housing (2),
a hollow cylindrical electrical conductor (8) positioned inside the housing (2),
a first electrode (5),
a second electrode (6), wherein the two electrodes (5, 6) are spaced apart from one another and form a spark gap (15) in the region of the conductor (8), and
a contact element (7) for making an electrical contact between conductor (8) and first electrode (5),
wherein the position of the first electrode (5) can be adjusted in order to modify the length of the spark gap (15),
wherein at least one contact region (9) of the contact element (7) is connected to the first electrode (5) or its holder (13) so as to resist movement, and
wherein the contact element (7) is deformable so that the opposing contact surfaces of conductor (8) and first electrode (5) remain in electrical contact even when the position of the first electrode (5) is adjusted with respect to the second electrode (6), wherein a further contact region (10) of the contact element (7) is connected to the hollow cylindrical electrical conductor (8) so as to resist movement,
**characterized in that**
the contact element (7) comprises the following:
an inner contact region (9), which is provided for making electrical contact with the first electrode (5) or its holder (13),
an outer contact region (10), which is provided for making electrical contact with the hollow cylindrical electrical conductor (8), and
an intermediate region, which comprises a plurality of deformation sections and apertures (12),
**in that** a clamp connection, screw connection, welded connection, soldered connection or electrically conducting glued connection is provided to produce the movement-resistant electrical connections, and
**in that** the contact element (7) engages in a gap (14) provided between first electrode (5) and its holder (13).

2. Arrangement according to Claim 1,
wherein the contact element (7) is elastically deformable.

3. Arrangement according to Claim 1,
wherein the contact element (7) is plastically deformable.

4. Arrangement according to any of the preceding claims,
wherein the deformation sections are spring elements (11).

5. Arrangement according to any of the preceding claims,
wherein the deformation sections or spring elements (11) project above an imaginary connecting plane between inner contact region (9) and outer contact region (10).

6. Arrangement according to any of the preceding claims,
wherein the deformation sections or spring elements (11) are in the form of a wave or an angle.

7. Arrangement according to any of the preceding claims,
wherein the inner contact region (9), the outer contact region (10) and the deformation sections or spring elements (11) have identical material thicknesses.

8. Arrangement according to any of the preceding claims,
wherein the deformation sections or spring elements (11) are in the form of a strip or in the form of a wire.

9. Microwave generator with an impulse voltage circuit and a spark gap (7) arranged between a first electrode (5) and a second electrode (6), wherein the position of the first electrode (5) can be changed in order to change the length of the spark gap,
**characterized in that**
the microwave generator (1) comprises an arrangement according to at least one of the preceding claims.

## Revendications

1. Ensemble de résonateurs destiné à un générateur de micro-ondes (1) comprenant :
un boîtier (2),
un conducteur (8) électrique cylindrique creux, positionné à l'intérieur du boîtier (2),
une première électrode (5),
une deuxième électrode (6), les deux électrodes (5, 6) étant écartées l'une de l'autre et formant dans la zone du conducteur (8) un éclateur (15), ainsi qu'un élément de contact (7), destiné à établir un contact électrique entre le conducteur (8) et la première électrode (5),
la position de la première électrode (5) étant ajustable pour adapter la longueur de l'éclateur (15),
au moins une zone de contact (9) de l'élément de contact (7) étant en liaison solidaire en déplacement avec la première électrode (5) ou la fixation (13) de celle-ci et l'élément de contact (7) étant déformable, de sorte que des surfaces de contact opposées du conducteur (8) et de la première électrode (5) restent en contact électrique, également lors d'un ajustement de la position de la première électrode (5) par rapport à la deuxième électrode (6),
une zone de contact (10) supplémentaire de l'élément de contact (7) étant en liaison solidaire en déplacement avec le conducteur (8) électrique cylindrique creux,
**caractérisé**
**en ce que** l'élément de contact (7) comprend ce qui suit :
une zone de contact (9) interne qui est prévue pour la mise en contact électrique de la première électrode (5) ou de sa fixation (13),
une zone de contact (10) externe, qui est prévue pour la mise en contact électrique du conducteur (8) électrique cylindrique creux, ainsi
qu'une zone située entre celles-ci, qui comprend une pluralité de sections de déformation, ainsi que d'ajours (12),
**en ce que** pour établir les liaisons électriques solidaires en déplacement, il est prévu une liaison par bornes, une liaison par vissage, une liaison par soudage, une liaison par brasage ou une liaison adhésive conductrice d'électricité et
**en ce que** l'élément de contact (7) s'engage dans une fente (14) prévue entre la première électrode (5) et sa fixation (13).

2. Ensemble selon la revendication 1, l'élément de contact (7) étant élastiquement déformable.

3. Ensemble selon la revendication 1, l'élément de contact (7) étant plastiquement déformable.

4. Ensemble selon l'une quelconque des revendications précédentes, les sections de déformation étant des éléments à ressort (11).

5. Ensemble selon l'une quelconque des revendications précédentes, les sections de déformation ou éléments à ressort (11) excédant dans la hauteur un plan de liaison virtuel entre la zone de contact (9) interne, ainsi que la zone de contact (10) externe.

6. Ensemble selon l'une quelconque des revendications précédentes, les sections de déformation ou éléments à ressort (11) étant conçu(e)s sous forme ondulée ou coudée.

7. Ensemble selon l'une quelconque des revendications précédentes, la zone de contact (9) interne, la zone de contact (10) externe, ainsi que les sections de déformation ou éléments à ressort (11) présentant des épaisseurs de matière identiques.

8. Ensemble selon l'une quelconque des revendications précédentes, les sections de déformation ou éléments à ressort (11) étant conçu(e)s en forme de bande ou en forme de fil métallique.

9. Générateur de micro-ondes pourvu d'un circuit à surtension transitoire, ainsi que d'un éclateur (7) placé entre une première électrode (5) et une deuxième électrode (6), la positon de la première électrode (5) étant ajustable pour adapter la longueur de l'éclateur, **caractérisé en ce que** le générateur de micro-ondes (1) comprend un ensemble selon au moins l'une quelconque des revendications précédentes.
